Europäisches Patentamt

European Patent Office

Office européen des brevets

(19)

(11) EP 0 889 975 B1

(12) EUROPEAN PATENT SPECIFICATION

(45) Date of publication and mention
of the grant of the patent:
**07.06.2000 Bulletin 2000/23**

(21) Application number: **96905965.8**

(22) Date of filing: **29.03.1996**

(51) Int Cl.[7]: **C23C 16/18**

(86) International application number:
**PCT/IB96/00262**

(87) International publication number:
**WO 97/37057 (09.10.1997 Gazette 1997/43)**

(54) **DEPOSITION METHOD AND USE OF A PRECURSOR THEREFOR**

VERFAHREN ZUR ABSCHEIDUNG UND VERWENDUNG EINES VORPRODUKTS HIERFÜR

PROCEDE DE DEPOT ET UTILISATION D'UN PRECURSEUR A CELA

(84) Designated Contracting States:
**DE FR GB**

(43) Date of publication of application:
**13.01.1999 Bulletin 1999/02**

(73) Proprietors:
- **International Business Machines Corporation**
  **Armonk, N.Y. 10504 (US)**
- **Berke, Heinz**
  **8484 Weisslingen (CH)**
- **Huber, J. Robert**
  **8006 Zürich (CH)**

(72) Inventors:
- **BERKE, Heinz**
  **CH-8484 Weisslingen (CH)**
- **HUBER, J., Robert**
  **CH-8006 Zürich (CH)**
- **ARROUY, Frédéric**
  **F-33410 Rions (FR)**
- **BEDNORZ, Johannes, Georg**
  **CH-8633 Wolfshausen (CH)**
- **FRITSCH, Elke**
  **D-81737 München Neu Perlach (DE)**
- **LOCQUET, Jean-Pierre**
  **CH-8803 Rüschlikon (CH)**
- **MAECHLER, Erich**
  **CH-8854 Siebnen (CH)**

(74) Representative: **Klett, Peter Michael**
**IBM Research Laboratory**
**Intellectual Property Department**
**Säumerstrasse 4**
**8803 Rüschlikon (CH)**

(56) References cited:
US-A- 3 372 055          US-A- 4 686 116
US-A- 4 722 860

- **JOURNAL OF VACUUM SCIENCE AND TECHNOLOGY: PART A, vol. 8, no. 5, 1 September 1990, US, pages 3701-3706, XP000217252 KIRCH S J ET AL: "SPONTANEOUS DECOMPOSITION OF DIMETHYL GOLD HEXAFLUOROACETYLACETONATE ON ION BOMBARDED SURFACES"**
- **JAPANESE JOURNAL OF APPLIED PHYSICS, vol. 30, no. 6B, 15 June 1991, JP, pages L1118-L1120, XP000224845 NOBUYUKI SUGII ET AL: "THE EFFECT OF MICROWAVE-PLASMA ON DECOMPOSITION AND OXIDATION OF BA(THD)2"**
- **APPLIED PHYSICS LETTERS, vol. 60, no. 11, 16 March 1992, US, pages 1402-1403, XP000263341 COHAN J S ET AL: "LASER-ASSISTED ORGANOMETALLIC CHEMICAL VAPOR DEPOSITION OF FILMS OF RHODIUM AND IRIDIUM"**
- **CHEMICAL ABSTRACTS, vol. 124, no. 4, 22 January 1996, US, page 71 XP002020345 SOKOLOVA: "PLASMA-CHEMICAL DEPOSITION OF COATINGS ON THE SURFACE OF POLYMER MATERIALS USING ORGANOMETALLIC COMPOUNDS."**

**Description**

This invention relates to a method of depositing high-purity metals (viz copper, silver, rhodium and/or iridium) or metal compounds like oxides, nitrides, fluorides and the like. It also concerns a new use of precursors for this deposition method and a deposition method using these precursors.

BACKGROUND OF THE INVENTION

The deposition of metals from the vapor phase is important in many industries, and in particular in the electronics industry. In this industry, metallic depositions are often undertaken, involving metals such as copper, silver, gold, tungsten or the like. In particular, these metals are often used for interconnection lines and for packaging of semiconductor chips or integrated circuits (ICs).

Another application of metals is their deposition as layers for thin film devices, such as magnetic head assemblies, displays and recording media for data storages. Yet another important field is the preparation of high-$T_c$ superconducting devices, which at least currently all comprise a layer of copper oxide.

Chemical vapor deposition (CVD) is especially suitable to provide conformal deposition which by evaporation or sputtering cannot be achieved. In the microelectronics industry as well as in other industries it is often the situation that the deposition must occur onto substrates which have irregular topography, such as nonplanar surfaces, including steps or the like. CVD however often suffers from problems such as poor film quality, high processing temperatures, incorporation of impurities and other defects in the deposited films, the inability to transport vapors of the metal complex without decomposition of the vapors and the instability of the precursors used in the deposition systems.

Thermal, plasma-, ion-, and laser-induced deposition of metals from the gas phase has been attempted in the art. Published studies generally describe metals and elements whose volatile precursors are readily available from metal alkyls or metal carbonyls. Also more sophisticated metal complexes have been used.

Among those complexes are metal salt/phosphine complexes derived from a nonorganometallic salt of a heavy metal and a triorganophosphine as disclosed in U.S. Pat. No. 3,438,805. The substrate temperature for the deposition lies between 25 °C and 350 °C.

A similar method using such complexes which are useful in chemical or electroless plating is described in US 3,625,755.

U.S. Pat. No. 3,700,693 is directed to the preparation of certain fluororganocopper compounds which are soluble in inert aprotic solvents and which are useful for copper coating. The solved compound is to be adhered to a substrate and subsequently thermally decomposed. The temperature range used therefor lies between 0 °C and 350 °C.

US 3,817,784 deals with the same matter of liquid coating and covers a temperature range of -20 °C up to 350 °C.

U.S. Pat. No. 3,933,878 is directed to ligand complexes of Cu(I) salts which are manufactured by contacting a Cu(I) salt with a ligand such as a trialkyl phosphine complex. Thereby the mixture can be heated up to 170 °C. The liquid Copper salt is used as a complexing agent for separating complexible ligands from feed streams.

Australian Patent No. 145,054 discloses compositions for chemical or electroless plating of copper, silver, gold and other metals from a bath containing a salt of the metal and pentanedione-2,4.

European published Patent application No. 0,297,348 is directed to a method for chemical vapor deposition of copper, silver, and gold on a substrate using a cyclopentadienyl metal complex. Thermal CVD as well as radiation beam-induced CVD is used. CVD includes any type of apparatus in which the substrate and/or the gaseous precursor is heated to a temperature sufficient to cause the decomposition of vapors of the precursor complex. When metal precursor vapors are introduced into the reactor and transported to the vicinity of the substrate, they decompose there to deposit the metal. In radiation beam reactors a beam, such as a laser beam, is used to heat the substrate and/or the gaseous precursor, whereas in thermal CVD a thermal reactor is used. The temperature of the substrate is thereby tried to be kept low in order to be able to use the deposition technique in the presence of other layers having temperature-sensitive properties and for instance to preserve necessary characteristics of underlying layers. For example, most photosensitive resists cannot be subjected to temperatures above about 175 °C without losing their ability to be exposed, developed and patterned. The low temperature requirement for the deposition of transition metals is most easily met by the decomposition of an organometallic compound. However for certain metals such as copper, this is made difficult by the instability of organocopper compounds and their tendency to form nonvolatile oligomers and polymers. For example binary alkyl copper complexes undergo autocatalytic decomposition to alkanes or alkenes and copper metal at temperatures too low for the compounds to have sufficient volatility. In the case of binary arylcopper complexes, these materials are more stable but their oligomeric structure lowers their volatility to the point that decomposition occurs before transport. The disclosed precursor for low-temperature deposition is a group IB metal cyclopentadienyl complex coordinated by a 2 electron donor ligand, such as a phosphine ligand. As an example of a suitable precursor complex for the deposition of copper trialkylphosphine (cyclopentadienyl copper I) complexes are used to deposit analytically pure copper at temperatures between about 120 °C and 220 °C.

U.S. Pat. No. 3, 356, 527 is directed to the use of trifluoroacetylacetonates and hexafluoroacetylacetonates of metal(II)-hydrates, -halides, alkyl-, aryl-, hydroxyl- and nitro-compounds (e.g. copper(II), nickel, cobalt(II) and lead) in chemical vapor deposition processes. Such processes require the use of a carrier/reducing gas, namely hydrogen, hydrazine, carbon monoxide or the like.

Oehr and Suhr, Appl. Phys. A45, pp. 151-154 (1988) "Thin Copper Films by Plasma CVD using Copper-Hexafluoro-Acetylacetonate" discloses the preparation and use of copper-hexafluoro-acetylacetonate in the plasma-enhanced chemical vapor deposition (PECVD) of thin copper films. PECVD is a deposition method which includes the decomposition of the precursor in the glow-discharge area of an ionized gas. The mean free path length, being the distance between two probable collisions, is therefore kept short in order to obtain collisions between the precursors and the ions of the plasma in the gas phase. The process requires the use of hydrogen in order to obtain deposited metal films. Otherwise only polymeric films are obtained. It is assumed that the hydrogen contributes to the formation of stable volatile organic compounds from the ligands and the reduction of the copper. The substrate temperature lies in the range of 303 to 473 K, i.e. 30 °C to 200 °C.

DE-OS 3510982 describes also a PECVD method which includes the decomposition of a metal organic precursor in the glow-discharge area of an ionized gas. For the provision of metal atoms in the glow discharge zone, metal organic compositions are used which are volatile in the used chamber pressure range. They can be used in pure form or as well in combination with a carrier gas in order to obtain homogeneous layers without pores. Carrier gases can be gases like argon, helium or reducing gases like hydrogen. Also combinations of them can be used. The deliverance of the metal organic compositions is done through joining a stream of the volatile precursors together with a stream of the carrier gas somewhere separated from the glow discharge area. The combined gas is directed to the glow discharge area where the homogeneous gas mixture can be decomposed. The precursor supply has a heating apparatus for volatilizing the precursor.

Houle et al., Appl. Phys. Lett. 46, 15 January 1985, pp. 204-206, "Laser chemical vapor deposition of copper" describes laser-induced chemical vapor deposition of copper using a volatile copper coordination complex. The source of copper for these studies was bis-(1,1,1,5,5,5-hexafluoro-2,4-pentanedionate) copper (II), CuHF.

Thermal CVD of copper has also been reported from other precursors such as copper chloride ($CuCl_2$) and copper acetylacetonates ($Cu(C_5H_7O_2)_2$). The copper chloride system requires the addition of hydrogen as a reducing agent and operates at temperatures of 400 °C to 1200 °C. The products of the reaction are copper and hydrogen-chloride (HCl), and a reasonable mechanism for this reaction probably involves disassociative chemisorption of both reactants followed by a surface reaction to make HCl which then desorbs. When copper is deposited from copper(II)-bisacetylacetonate, such process may or may not include hydrogen reactants or carrier gases. Generally, deposition of copper from these sources results in copper films of lower quality, i.e. lower purity and higher resistivity.

Another method of CVD of copper, silver and gold using a cyclopentadienyl/metal complex is described in U.S. Pat. No. 4,948,623 providing thus a class of precursors which decompose at particularly low temperatures (120°C - 250°C).

U.S. Pat. Nos. 5,096,737 and 5,220,044 are directed to ligand stabilized +1 metal beta-diketone coordination complexes and their use as precursors in CVD. These precursors are extremely heat sensitive and decompose at temperatures as low as 180 °C.

The European Patent Application No. 0,207,759 discloses a vapor deposition process for depositing a substantially amorphous multi-metallic coating on a substrate by providing precursor metal-bearing compounds that contain the metals which are desired to be embedded in the amorphous multi-metallic coating and which decompose at a temperature below the crystallization temperature of the amorphous multi-metallic coating to be formed, heating the substrate in an enclosed system to a temperature of at least the decomposition temperature of the precursor compounds, volatilizing the precursor compounds and contacting the precursor compounds with the substrate in the enclosed system so as to cause the substantially amorphous multi-metallic coating to be formed on the substrate. Thereby also precursor compounds containing phosphorous, boron, nitrogen, arsenic, sulfur, silicon and carbon are introduced into the enclosed system so as to cause the introduction of these elements into the substantially amorphous multi-metallic coating. The precursor compounds suitable for use in this process may include organo-metallic compounds such as monomers, dimers, trimers and polymers having metallo-organic ligands composed of saturated and/or unsaturated hydrocarbons, aromatic or heteroaromatic ligands. The decomposition temperatures range around 75 °C to 200 °C. The substrate temperature required for most deposition reactions is from about 250 °C to about 400 °C. The atmosphere maintained in the enclosed system may be a vacuum, an inert atmosphere or a reactive atmosphere.

The publication "Preparation and electrical properties of polymeric copper phthalocyanine thin films by plasma polymerization" by Yoshihito Osada and Akira Mizumoto in Journal of Applied Physics, 59 (5), 1 March 1986, pages 1776-1779 describes the use of copper phthalocyanine as a precursor for the deposition of the same on a substrate. Therefore a low temperature plasma is used. The obtained film is a phthalocyanine polymer.

The principle molecular structure of porphyrins, of which phthalocyanines are a subsection, is shown in "Electronic Distinction between Porphyrins and Tetraazaporphyrins. Insights from X-Ray Photoelectron Spectra of Free Base Porphyrin, Parphyrazine, and Phthalocyanine Ligands" by Ghosh, Fitzgerald, Gassman and Almlöf in Inorganic Chemistry 1994, 33, pages 6057-6060. It is described that metallo-phthalocyanines offer a very high stability.

In U.S. Patent No. 4,321,073 a method and an apparatus for forming metal coating on glass fibers is described. Thereby the surface of the fiber is heated by radiation in order to prevent deposition of metal on the walls of the deposition chamber. The metal-containing compound is introduced into the chamber for instance in vapor form. Preferably this vapor is diluted with a mildly reducing gas to improve efficient utilization of the dissociated metal and to prevent oxidation of the metal during the deposition process. The use of a hydrogen-containing gas stream is contemplated to recycle the organic ligand.

In "Plasma-Chemical Deposition of Coatings on Surface of Polymer Materials using Organometallic compounds" by Sokolov et al. in Izv. Vyssh. Ucheb. Zaved. Khim. Khim Teekhnol., 1995, an investigation of the laws governing the formation of metal-containing compounds on the surface of polymer materials in glow discharge using organometallic compounds is described. A substrate, e.g. made of polyethylene, is provided with a coating based on copper phtalocyanine and copper acetylacetonate. Therfor the substrate is arranged between two flat electrodes. The organometallic compound vapours from the thermally heated ampoule containing the substance and enters the discharge zone through an opening in the anode. The results suggest that, through variation in the processing conditions, different-coloured films with good adhesion of the deposited layer to the polymer substrate can be obtained by the plasma-chemical deposition method.

In "Laser-assisted organometallic chemical vapor deposition of films of rhodium and iridium" by Judson S. Cohan et al., Appl. Phys. Lett. 60 (11), 16 March 1992, the manufacturing of high-purity thin films of rhodium and iridium metal by laser-assisted organometallic chemical vapor deposition is investigated.The depositions are carried out in an atmosphere of He and H2 at room temperature and atmospheric pressure. It is shown that only irradiation into the compund's charge transfer band causes a deposition.

A shuttered growth process such as the block-by-block deposition method is described by J.-P. Locquet and E. Maechler in: MRS Bulletin, Vol. XIX, No. 9, Sept. 1994, pages 39-43.

While the prior art generally recognizes the desirability of chemical vapor deposition of metals particularly copper, precursors and techniques previously tried tended to lower the decomposition temperature of the precursor compound, resulting in molecules of poor thermal stability. These molecules require a very delicate deposition procedure and conditions, thus restricting their use to a limited number of applications.

The use of precursors with a high decomposition temperature, in summary is discredited in the art. In the past the use of high-temperature precursors led to the deposition of films with minor quality due to high levels of carbon and/or oxygen. Further the condensation of precursors in a reaction chamber is mostly discredited because the same condensation occurred in the precursor supply lines and led to congestion.

It is therefore an object of this invention to provide a new use of precursors for the deposition of a metal whose atom or atoms are included in the precursor which offer a relatively high decomposition temperature and can nevertheless be used for thermal, plasma-, ion- or laser-induced deposition of metals in a chemical beam deposition process or related processes without encountering the problems described in the previous paragraphs.

It is a further object of this invention to provide a new deposition method which takes place at temperatures below the decomposition temperature of the used precursors and therefore is useful for decomposing very stable precursors.

SUMMARY AND ADVANTAGES OF THE INVENTION

The object of the invention is achieved by a deposition method as set forth in claim 1 and a use of a precursor as set forth in claim 9.

Several advantages are connected with the use of a deposition process in accordance with the present invention.

The new method according to claim 1 offers the advantage that due to non-thermal decomposition relatively stable precursors with relatively high decomposition temperatures can be decomposed at relatively low substrate temperatures. The introduction of a decomposition means which directly decomposes the precursor, or with other words which suffices to decompose the precursor without any structural conversion of the decomposition means, offers an excellent controllability for the decomposition process because the amount of active decomposition means can be determined exactly at the entry position where the decomposition means is introduced into the reaction chamber.

Further the substrate temperature can be chosen independent from the decomposition temperature and hence be chosen to satisfy best growth conditions for the metal or the compound. In other words the decomposition process is decoupled from the deposition process.

Additionally the low substrate temperature leads to a lower wall temperature of the reaction chamber and hence to a lower reevaporation rate. Therefore the number of reevaporating precursor molecules in the atmosphere, contributing to the background pressure in the reaction chamber is significantly reduced. For a shuttered growth process this means an increased controllability of the deposition process.

The new deposition process allows to decouple the decomposition process from the deposition process. As a consequence, under the condition that the evaporation rate of the precursor is much larger than the flux of the decomposition means and that the substrate temperature is such that reevaporation occurs on the substrate, the deposition is no longer directly determined neither by the substrate temperature nor by the evaporation rate but mainly by the flux of the decomposition means . Since the precursor molecules remain stable at the substrate temperature, they simply reevaporate unless they are cracked by the decomposition means. In contrast to known (MBE) deposition techniques, it is hence not required to stabilize the fluxes of all precursor molecules involved in the process. Instead, it is sufficient to control only the flux of the decomposition means to obtain a constant deposition rate. A calibration step is only needed once per precursor type to estimate the decomposition efficiency, i.e. the amount of the decomposition means needed to decompose a specific amount of the precursor molecules. In case that various precursors in a multi-component deposition process are all cracked by an equal amount of the decomposition means, it suffices to control the time during which the substrate is exposed to the flux of the decomposition means to control the entire deposition process. The decomposition rate is not thermally controlled but controlled by the rate of the decomposition means. Even when the precursors and the decomposition means are stopped from evaporation by shutters which are leaky, which normally is the case, decomposition is fully controllable.

A long enough mean-free-path-length lets decomposition occur directly on the surface of the substrate body due to the remanence time of the precursor molecules and of the decomposition means. Thereby material losses are substantially reduced in comparison to gas phase reacting processes.

The use of chemical reactive species proves particularly advantageous due to the simplified producibility and availability of such chemical reactive species. Furthermore the chemical reactive species can be used at the same time as reactant partner for the decomposition process to remove superfluous cracking residues or even include them for the composition of a deposited compound.

An electromagnetic beam, particularly a laser beam is especially practicable for depositing patterns of the metal or metal compound.

To obtain the most used and most wanted compounds, decomposition means in the form of chemical aggressive compounds like HF, $NO_2$, or chemical reactive radicals like $NH_2$·, NO·, OH. or ionic species of molecules or atoms like $Ar^+$, $O^-$, $N^-$, $O_2^-$ or electrons are best for use, because they are readily available and show highest reactivity. Also atomic species are suitable like for instance N, $CH_x$-radicals, O, C, H. The enumerated species can be used alone but also in arbitrary combinations. The above enumeration is only for example and shall not be seen as complete list.

A catalytic species is particularly useful because it can be chosen to serve as a reactant partner for forming the deposited layer. It can even be introduced into the reaction chamber being already deposited on or part of the substrate body. Then an introduction of the catalytic species during the process can be avoided.

In general a metal with a porphyrine derived ligand, in particular a porphyrin, and even more particularly a phthalocyanine is suitable for use in the invented method because these are very stable molecules concerning time, temperature and pressure and hence are difficult to be decomposed thermally. They also have a high evaporation temperature which in the following is called volatility temperature which leads to a minimized reevaporation rate. Further these precursors can be used to deposit the most wanted metals and their compounds.

A special application of the invented method with these precursors is the creation of superconductive layers with high quality.

DESCRIPTION OF THE DRAWINGS

The invention is described in detail below with reference to the following drawings:

FIG. 1 depicts an apparatus to carry out the invented method.

FIG. 2 depicts a schematic view of a precursor molecule in accordance with the invention.

DESCRIPTION OF THE INVENTION

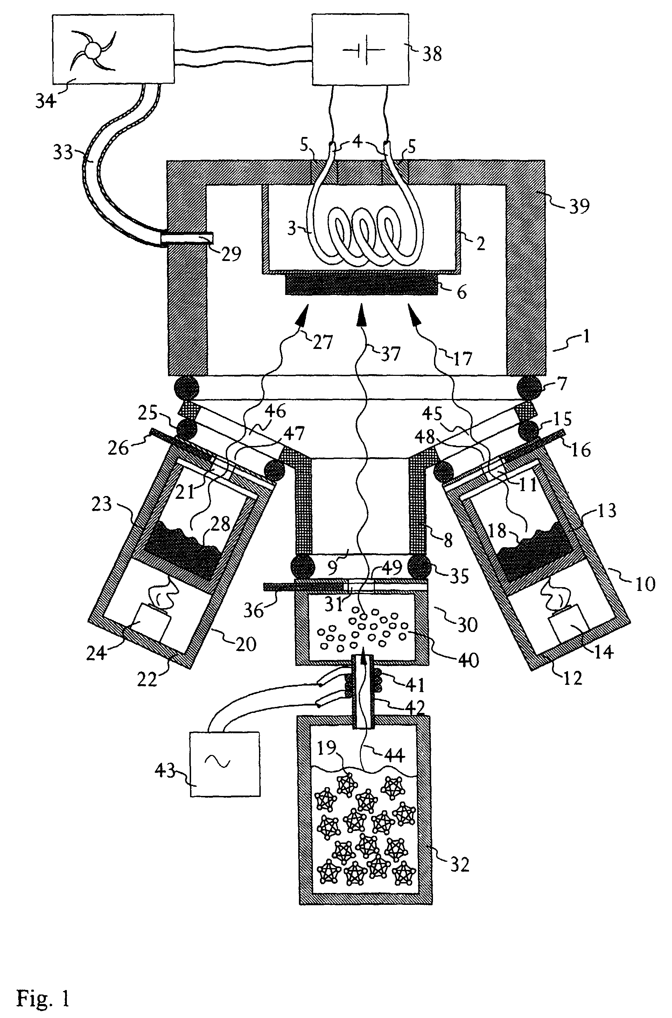

In figure 1 is shown an apparatus for chemical vapor deposition. In the interior of a cylindrical, pot-shaped reaction chamber 1 is arranged a cylindrical pot-shaped substrate holder 2 in whose interior a heating spiral 3 is arranged. The heating spiral 3 comprises a helix and two connection terminals 4 which are held by heat-insulating lead-throughs 5 in the bottom wall of the reaction chamber 1. The substrate holder 2 holds a substrate body 6 which here is realized in form of a flat substrate plate . The reaction chamber 1 comprises in its top wall a first opening 11 which is surrounded by a first gas-tightening ring 7, for instance made of metal or ribbon. A lid 8 situated on the first gas-tightening ring 7 comprises a frustum section on whose narrow top is mounted a cylindrical section. The lid 8 hence has a domelike shape. The frustum section has a first round aperture 46 and a second round aperture 45. To the second round aperture 45 a first effusion cell 10 is attached, comprising a first cylindrical housing 12, having a first round opening 11 in its top wall. Near the first opening 11 is mounted a first shutter 16 in form of a slideable wall element. In the interior of the first cylindrical housing 12 is arranged a first reservoir 13 in which a supply for a first precursor 18 is located. The first reservoir 13 is shorter than the first cylindrical housing 12, and in the space between them a first heater 14 is arranged. The first effusion cell 10 is mounted on the second aperture 45 via a second gas-tightening ring 15. From the inside of the first effusion cell 10 a first molecular precursor beam 17 is reaching through the first opening 11 and the first gas-tightening ring 7 towards the substrate plate 6. On the first aperture 46 a second effusion cell 20 is arranged, having a second cylindrical housing 22 and a second opening 21 in its top wall which can be shut by a second shutter 26 and is fixed to the first aperture 46 via a third gas-tightening ring 25. In the interior of the second cylindrical housing 22 is arranged a supply for a second precursor 28 within a second reservoir 23 which can be heated through a second heater 24. From the inside of the second effusion cell 10 a second molecular precursor beam 27 is reaching through the second opening 21 and the first gas-tightening ring 7 towards the substrate plate 6. The cylindrical section of the lid 8 has also a third aperture 9 which is covered by the top wall of a cylindrical gas chamber 30 which includes a decomposing means 40. The cylindrical gas chamber 30 has an opening 31 in its top wall which also can be shut by a third shutter 36. Here the decomposing means 40 is realized in form of an atomic chemical reactive species. The gas chamber 30 is connected through a connection pipe 42 with a third cylindrical housing 32 which carries in it a molecular precursor base material supply 19. The connection pipe 42 bears a coil 41 which is connected with a RF electronic power source 43. From the molecular precursor base material supply 19 a molecular precursor base material beam 44 is reaching into the gas chamber 30 from which a decomposition means 37 in form of a chemical reactive species beam is reaching through the third opening 31 towards the substrate plate 6. The first opening 11 defines a first introduction position 48, as well as the second opening 21 defines a further first introduction position 47. The third opening 31 defines a second introduction position 49. Further the reaction chamber 1 comprises a flange or nipple 29 protruding through the side wall of the reaction chamber 1 and being attached to a hose 33 which leads to a vacuum pump 34. The electrical power supply 38 also provides energy to the vacuum pump 34.

For the ensuing description of the invention's principle the second effusion cell 20 and all related parts of it are for the present ignored.

Through the vacuum pump 34 via the hose 33 and the flange 29 air and gases can be pumped out of the reaction chamber 1. This is used to control the pressure in the reaction chamber 1. To produce the first molecular precursor beam 17 of the first precursor 18, the first precursor 18 which is placed in the first effusion cell 10 is heated up to an effusion cell temperature $T_e$ that suffices to create a vapor of the first precursor 18, i.e. a procedure very similar to that used in a standard Molecular Beam Epitaxy (MBE) or Chemical Vapor Deposition (CVD) deposition process. The temperature $T_e$ in the first effusion cell 10 must hence be at least as high as the volatility temperature $T_v$ of the first precursor 18. The volatility temperature $T_v$ is usually defined as the temperature at which between 1 Å/s and 1 Å/min of the precursor material of the first precursor 18 is deposited on the substrate plate 6. However, since the evaporation function has an exponential shape, other definitions might as well be applied, depending on the chosen process conditions.

$$(I) \qquad T_e \geq T_v$$

The first shutter 16 is used to control the flux of the first molecular precursor beam 17 evaporating from the first effusion cell 10 and can be opened to allow full evaporation and be closed to stop evaporation from the first effusion cell 10 versus the substrate plate 6. With the first shutter 16 opened, the first molecular precursor beam 17 exiting from the first effusion cell 10 is directed onto the surface of the substrate plate 6. The substrate plate 6 is heated through the heating spiral 3 and thereby has a substrate temperature $T_s$. The first precursor 18 has as a material dependent physical constant a decomposition temperature $T_{cr}$, also called cracking temperature. This temperature is here broadly defined as the temperature at which nearly all precursor molecules are cracked during the time of the experiment, i.e. typically a few minutes or hours. Nevertheless this definition can vary and be chosen differently. For thermal decomposition the substrate temperature $T_s$ is chosen at least as high as the cracking temperature $T_{cr}$ of the first precursor 18.

$$(II) \qquad T_s \geq T_{cr}$$

To obtain a metal layer on the substrate plate 6 the first precursor 18 has to include one or more atoms of this metal. Through the decomposition of the first precursor 18 the metal atom or atoms are set free and can stick at the surface of the substrate plate 6 to form a deposited layer.

A material chosen for the first precursor 18 to be suitable for any decomposition process has to show a cracking temperature $T_{cr}$ which is higher than the volatility temperature $T_v$. The effusion cell temperature $T_e$ is of course to be chosen lower than the cracking temperature $T_{cr}$, in order to prevent the first precursor 18 from being cracked, i.e. decomposed already in the first effusion cell 10.

$$(III) \qquad T_{cr} > T_v$$

$$(IV) \qquad T_{cr} > T_e$$

The wall of the reaction chamber 1, i.e. the wall of the reaction chamber housing 39 is not artificially cooled and hence also unavoidably heated by the heat radiating from the heating spiral 3 as well as from the effusion cells 10, 20 via the substrate holder 2. The wall temperature $T_w$ will of course always be lower than the substrate temperature $T_s$.

$$(V) \qquad T_w < T_s$$

With known processes using precursor materials with low volatility temperatures, namely a process of thermal decomposition or plasma enhanced deposition, the phenomenon occurs that the first molecular precursor 18 beam does not condensate at the wall of the reaction chamber 1 but reevaporates. This leads to a deteriorated controllability of the composition of the layer to grow on the substrate plate 6 due to reevaporating molecules of the first precursor 18 contributing additionally to the growth process. This becomes most important when the first shutter 16 is closed in order to stop the process, and reevaporation pertains for a certain while after the shutter 16 has been closed. To overcome this drawback the wall temperature $T_w$ has to be lowered. In the art so-called cryopanels are used which cool the chamber wall artificially, for instance with a flowing liquid. However, cryopanels serve only to reduce the wall temperature $T_w$ in accessible and suited regions , but can not eliminate all hot areas of the reaction chamber 1. Here no artificial cooling is used because such cooling mechanisms are expensive and need additional space.

Because the volatility curve of the material of the first precursor follows an exponential function versus the temperature it does not suffice to keep the wall temperature $T_w$ a little lower than the volatility temperature $T_v$. To suppress this problem in a sufficient manner the following condition is to be solved:

$$(VI) \qquad T_w << T_v$$

When this condition VI is satisfied, the vapor of the first precursor 18 will mainly condensate at the chamber wall and stick there. By the condensation of the first precursor 18 reevaporation is reduced and the achieved decomposition rate is only dependent on the evaporation rate of the first precursor 18 of the first effusion cell 10. Two methods hence exist to fulfill condition VI: To alter the volatility temperature $T_v$ or to lower the wall temperature $T_w$. The first method together with equation III requires a higher cracking temperature $T_{cr}$.

With a higher cracking temperature $T_{cr}$ of course a higher substrate temperature $T_s$ is required for thermal decomposition. Thereby the possibilities to choose the substrate temperature $T_s$ equal to the optimal temperature for the growth of the layer which is to be deposited, are restricted. This limits the choice of depositable metals or compounds. As well other disadvantages exist, like the problem of damaging existing layers by a very high substrate temperature $T_s$ .

The first idea of the invention is to utilize a new process, namely one with which decomposition below the cracking temperature $T_{cr}$ is achieved, i.e. non-thermal cracking.

$$(VII) \qquad T_s < T_{cr}$$

To achieve non-thermal cracking the decomposition means 40 is used. Thereby also the second above mentioned method is simultaneously used, namely to lower the substrate temperature $T_s$. With the invented process the decomposition of any volatile metalorganic precursor below its thermal cracking temperature $T_{cr}$ is possible.

The molecular base material 19 is in this example a molecular gas like oxygen, which is readily volatile at room temperature. This gas forms the molecular base material beam 44 which undergoes an ion bombardment in the RF-Electrical Field of the coil 41. Thereby the molecular base material 19 is converted into the atomic chemical reactive species 40. In this special case the molecular oxygen $O_2$ is changed into atomic oxygen O or also ionized oxygen $O^-$ and $O_2^-$. These different species are extremely chemical reactive and form the chemical reactive beam 37 which is directed towards the substrate plate 6. The pressure regime inside the reaction chamber 1 is determined by the pressure caused by the vacuum pump 34 and by the emission rates, i.e. evaporation rates of the first molecular precursor beam 17, its decomposition products and the chemical reactive beam 37. The temperature and the pressure inside the reaction chamber 1 as well as the beam properties of the beams 17, 37 and the geometry of the reaction chamber 1 determine the mean-free-path-length among the chemical reactive beam 37 and the first molecular precursor beam 17. This mean-free-path-length is a variable which describes the probability of interaction between the various volatile reaction partners, particularly the mean distance between two probable collisions of the reaction partners. The mean-free-path-length is optimally chosen equal to or longer than the distance between the substrate plate 6 and the first introduction position 48 and also equal to or longer than the distance between the substrate plate 6 and the second introduction position 49. Because the probable number of interactions in the gas phase is a statistical process, of course also a shorter mean-free-path-length is acceptable, as long as the thereby caused decomposition is not the major or dominating process. In other words, the reaction partners should underlie Molecular Beam conditions which are defined by a small number of probable interactions in the gas phase. As an example a chamber pressure of $10^{-4}$ Torr (1 Torr = 1.33 x $10^2$ Pa) leads to a mean-free-path-length of 20 cm and a chamber pressure of $10^{-5}$ Torr (1 Torr = 1.33 x $10^2$ Pa) leads to a mean-free-path-length of 200 cm. Of course the most interesting area for the mean-free-path-length is the area where the reactive partners can meet each other. Consequently the dimensions of this area are to serve as the basis for eventual mean-free-path-length dimensioning.

Here the mean-free-path-length is chosen approximately equal to the reaction chamber dimension by determining the pressure to approximately $10^{-5}$ Torr (1 Torr = 1.33 x $10^2$ Pa) or lower. The chemical reactive species 40 as well as the molecules of the first precursor 18 are hence with very high probability not colliding with each other in the gas phase. They reach the surface of the substrate plate 6 as the target and remain on this surface for a certain time, which time is called the remanence time. During this remanence time the reacting partners react with each other. The chemical reactive species 40 is decomposing the precursor molecules by chemically reacting with them. This means that the chemical reaction is the dominating process to decompose the precursor molecules. Of course this process can be assisted additionally by thermal or plasma (ion bombardment) effects.

The main advantage is that the substrate temperature $T_s$ has no longer to be chosen at least equal to the cracking temperature $T_{cr}$ and hence can be chosen to satisfy other conditions. One of the most important conditions is the realization of a layer of high quality, i. e. with a minimal number of defects, such as grain boundaries or secondary phase inclusions. This becomes most important in the field of superconducting layers. Because known superconducting ceramics comprise a plurality of different layers of different chemical compounds or elements and a useful process to grow these layers is to grow one layer after the other (block-by-block), it is very helpful to provide on one hand for best growth conditions for the layer to grow, and on the other hand to set the conditions so as to not damage the underlying layers during the process, by choosing an optimal temperature.

Another point is the use of the process in combination with a control exerted via the first shutter 16. Because the decomposition is non-thermal and the substrate plate 6 can be held at a substrate temperature $T_s$ much lower than the decomposition temperature $T_{cr}$, the wall temperature $T_w$ is lower and the reevaporation rate from the walls is reduced, in the ideal case to zero. When the first shutter 16 is closed, evaporation from the first evaporation cell 10 immediately stops. Since with the new process the reevaporation rate is minimized, almost no precursor molecules arrive any more at the substrate plate 6 and the decomposition and deposition process stops at the moment the first shutter 16 is closed. By this the growth process can be controlled more exactly and with minimal contamination. This becomes most important for processes where different materials are to be deposited one after the other on the same substrate plate 6. With the new process only the precursor type which is actually evaporated is deposited and not the precursor types which have been evaporated before.

Furthermore, the decomposition rate for the metal or its compound is controllable through the evaporation rate of the decomposition means 40 from the gas chamber 30. This means that as long as the substrate temperature $T_s$ is higher than the volatility temperature $T_v$ and the effusion rate from the first effusion cell 10 is higher than the maximum rate which can be cracked by the effusing chemical reactive species 40, the effusion rate of the first precursor 18 needs not be stabilized. Since uncracked precursor molecules will reevaporate at the substrate plate 6 the effusion rate of the chemical reactive species 40 determines the decomposition rate up to a material-dependent calibration factor. This is a big advantage in particular for compounds where the ratio of the contained materials must be controlled accurately which is more difficult than the control of the effusion rate of the decomposition means 40. Especially when the decomposition means 40 is a chemical reactive species like atomic oxygen, the effective deposition rate can be easily measured and held constant at a wanted level. Also it is not so dependent on conditions like temperature, supply volume and others.

If the first shutter 16 and the third shutter 36 are leaky, as is often the case, the direct way between the substrate plate 6 and the first opening 11 as well as the third opening 31 is blocked but a diffusion path still exists. With the new process nevertheless no decomposition on the substrate plate 6 occurs, because any precursor molecule condenses at the walls of the reaction chamber 1 before it reaches the substrate plate 6 and the chamber interior is free of the chemical reactive species 40. Shuttered growth processes are also very important for the deposition of multilayers with well-defined interfaces, i.e. superlattices.

The invention proves even more suitable for the deposition of metal compounds because the chemical reactive species 40 can supply the compound partner for the metal. Thereby oxygen can be used to deposit an oxide, hydrogen for a hydride, fluorine for a fluorine a.s.o.

Now the second effusion cell 20 shall be taken into account. All in all it works in the same way as the first effusion cell 10. The second molecular precursor beam 27 enters the reaction chamber 1. With this arrangement a sequential as well as a simultaneous introduction of the first precursor 18 together with the second precursor 28 can be achieved. This simplifies deposition processes and allows different types of deposited layers. This arrangement is especially suitable for the formation of a superconducting ceramic like $YBa_2Cu_3O_7$, using a third effusion cell.

The invented method can be executed also with a substrate temperature $T_s$ which is very low and not the optimal temperature for crystal growth. For this case an additional step, a sort of post-annealing, can be done. This means that after condensing and decomposing the precursor into pieces at a relatively low temperature the substrate temperature $T_s$ is set to be equal to the optimal crystal growth temperature. This step can take place at any temperature and can particularly be executed under conditions where the optimal crystal growth temperature does not decompose any of the non-decomposed precursor molecules. Especially when the decomposition temperature $T_{cr}$ of the precursors 18, 28 is lower than the optimal crystal growth temperature this means that the post-annealing step has to take place in a chamber free of any precursor molecules since otherwise the known process of thermal decomposition applies. This post-annealing method is nevertheless best suitable for such precursors with a relatively low decomposition temperature $T_{cr}$.

The evaporation of the precursors 18, 28 can also be done by using energetic bombardment of precursor targets or spraying techniques.

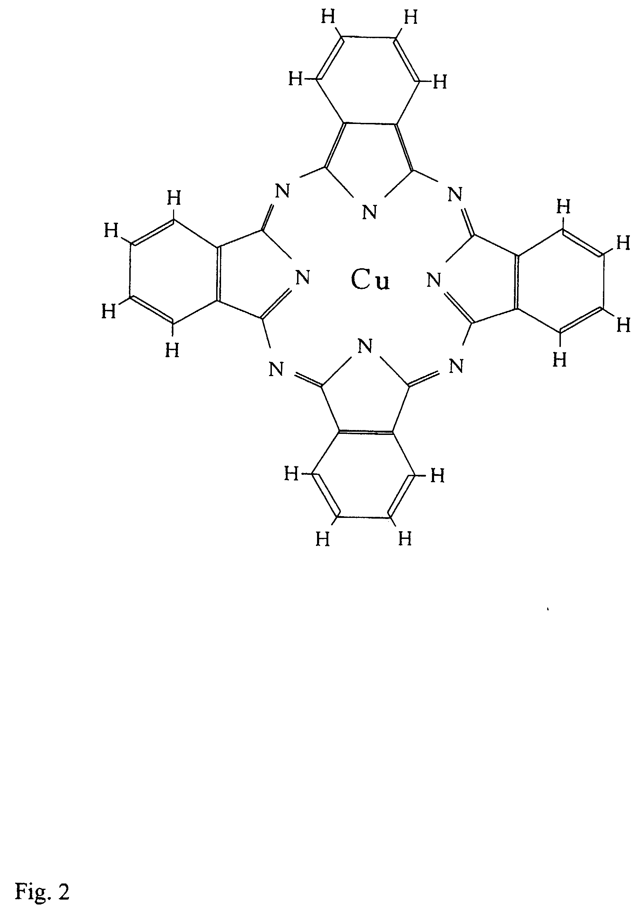

The invention also contains the idea to use a precursor material known per se as a precursor for decomposition. The precursor material contains one or several atoms of a metal and a porphyrine-derived ligand. Figure 2 shows an example for such a molecule, particularly Cu-phthalocyanine. A phthalocyanine is a compound which can be produced by heating phthalaciddinitrile in chinoline in presence of $NH_3$ or amines. The proposed precursor material is very stable and has a coin-like shape, i.e. with a very flat side area which results in a high sticking coefficient. The molecule has a high decomposition temperature, around 900 °C, which makes this material particularly hard to use for known decomposition methods and hence particularly useful for the invented non-thermal decomposition method. The volatility temperature for a Cu-phthalocyanine lies around 600°C. Another advantage of phthalocyanine is its low toxicity, in contrary to many known and used precursors for deposition of metals or their compounds.

In the following section possible applications of the invention for the deposition of a large series of thin films and multilayers are discussed. The mentioned precursor materials can be used for the synthesis of thin films and multilayers of elementary materials.

Thin films of metallic materials such as Cu, Co, Fe, etc. can be grown by using Cu-phthalocyanine, Co-phthalocyanine or Fe-phthalocyanine respectively as first precursor 18 and atomic hydrogen as the chemical reactive species 40 to crack the first metal-organic precursor 18 on the surface of the substrate plate 6.

For instance to produce an effusive beam of Cu-phthalocyanine or Co-phthalocyanine the effusion cell temperature $T_e$ to obtain a deposition rate of 10 to 100 Å/min is between 550 °C and 650 °C. As decomposition means 37 can be used a chemical reactive (neutral and/or ionic) species 40. Its flux can also be generated by using commercially available equipment, for example an RF-plasma-source such as manufactured by Oxford Applied Research (UK). The atomic chemical reactive species 40 is then for instance routinely produced with a flux of around $10^{16}$ atoms/scm². To initiate and to continue the growth, the chemical reactive species beam 37 is directed onto the surface of the substrate plate 6 at the same time that the first molecular precursor beam 17 is directed on the substrate plate 6. This procedure can however also be slightly delayed.

Thin films of metallic materials like Cu, Co, Fe, etc. can be grown by using a combination of the chemical reactive species 40 such as atomic oxygen, atomic nitrogen and atomic hydrogen, or even other, reactive species 40 like ions, photons or electrons. These elements can either be supplied simultaneously or in sequential order. Sources and processes for the generation of these species are well known in the art and therefore not described here. Examples where a given sequence might be beneficial are for instance those precursor molecules which decompose not efficiently using atomic hydrogen, but very efficiently using atomic oxygen. In this case a sequence would be a brief exposure using atomic oxygen to decompose the first precursor 18 and cause also a parasitic formation of an oxide, followed by an exposure to atomic hydrogen to reduce the oxide thereby obtaining a metallic film.

The proposed invention is well suited for the preparation of deposited alloys and deposited compound thin films. Thin films of alloys such as CuNi and $Nb_3Sn$ can also easily be made using the proposed precursor materials together with a single-atomic beam of the chemical reactive species 40 or a combination of such beams or a combination with other decomposition means 37. The control of the composition of the grown alloys can be performed by the measurement of the deposition rate using tools, i.e. quartz crystal microbalances. If the substrate temperature $T_s$ is chosen at a level, where the reevaporation rate at the substrate surface is very high, i.e., with a sticking coefficient at the substrate plate 6 close to zero, the amount of material effectively deposited on the substrate plate 6 is correlated alone to the flux of the decomposition means 37.

While these procedures are particularly useful for alloys and compound thin films, they can also be used in the case of elemental thin films.

Multilayers and Superlattices of elemental metals such as Cu, Co, Fe, Ni for the preparation of Cu/Cr, Cu/Co superlattices for example, can easily be grown using the above mentioned method by supplying sequentially the desired precursors 18, 28 together with either one decomposition means 37 or a combination of several decomposition means 37. Again the relative thicknesses of each of the layers can be determined by the method mentioned above.

Combinations of both alloys and multilayers include all type of composition gradients, special sequences in the multilayers (Fibonaci sequence for instance), buffer layers, protection coatings, and the like.

While in the previous case the decomposition means 37 can be chosen as chemical reactive species 40 for the decomposition which is hydrogen-related (atoms and/or ions), for the preparation of the compounds also other chemical reactive species 40 can be used. In general, for oxides, the main chemical reactive species 40 will be oxygen-related, for nitrides the main chemical reactive species will the nitrogen-related, while for hydrides it will be hydrogen-related.

Simple and complex oxides can be easily grown using the proposed method by supplying as the chemical reactive species 40 oxygen together with the first molecular precursor beam 17 to the substrate body 6. This can be done for simple oxides (such as $CuO$, $CoO$) and epitaxial films can easily be grown on appropriate substrate materials with appropriate temperatures.

More complex oxides can be grown by supplying for instance as first precursor 18 Cu-phthalocyanine and as second precursor 28 Co-phthalocyanine, thereby introducing different metals to the growing film surface, either in a sequential or a co-deposition manner using the composition control methods mentioned above. Again a combination of the decomposition means 37 can be used as well as a variety of compositions, profiles, gradients, buffer layers, etc. Another example is the growth of $YBa_2Cu_3O_7$ using such precursors 18, 28.

It is further within the scope of this invention to mix the precursors 18, 28 with a low decomposition temperature $T_{cr}$, such as for instance as first precursor 18 a Y(benzoylpivaloylmethanide)$_3$-precursor, together with the second precursor 28 with a high decomposition temperature such as Cu-phthalocyanine. Experiments have been made, yielding a number of good superconducting $YBa_2Cu_3O_7$-films using precisely these precursors 18, 28 together with Ba metal on $SrTiO_3$, using a source of atomic oxygen as the chemical reactive species 40 and a substrate temperature $T_s$ between 650 °C and 700 °C. These films were made using a sequential deposition technique (block-by-block) but can also be made using a co-deposition technique.

The same type of reasoning applies well to all compounds which require essentially one decomposition means 37 to build into the lattice (such as nitrides, carbides, hydrides, a.s.o. ), although for the effective cracking efficiency more than one decomposition means 37 can be used, as already described.

Oxy-nitrides can also be easily grown using the above mentioned procedure by a careful combination of the flux of the chemical reactive species 40 comprising atomic oxygen and atomic nitrogen, either in a combined reactive beam or in a sequential treatment using first one particular beam (oxygen first for instance) followed by the other one (nitrogen). The compounds can again be grown using a combination of more than two beams of chemical reactive species 40, such a first an atomic hydrogen beam followed by an oxygen and a nitrogen beam, respectively.

Complex compounds which require two or more chemical decomposition means 37 can also be grown using this technique, such as those incorporating (C-N), (H-N), (H-O), (C-H-N).

This invention can be used to prepare materials using an atomic species of any gas that is not monoatomic itself (such as $F_2$, $As_4$, etc. ) which can all be cracked and made very chemical reactive using the same plasma sources. Also an interesting combination will be a Ga precursor with an $As_4$ beam to produce GaAs films.

Other compounds or mixtures of any of the above categories as well as mixtures, multilayers, superlattices with the alloys can also be made as long as the material phase diagram allows such phases to coexist with one another at the growth temperature.

The method is suitable for the deposition of substantially pure metal, such as copper, silver, rhodium, or iridium. Generally used precursor materials are preferably based on porphyrine, in particular phthalocyanine, precursors derived from $\beta$-diketonates or $\beta$-diketonimines.

The decomposition means 40 can also be a catalytic species. This species then serves to lower the energy needed to decompose the first precursor 18 or second precursor 28. The lowered energy is then delivered by any means, such as temperature, chemical reactive species or the like. Because the substrate plate 6 will always be heated to the optimal growth temperature, heat will be the most suitable energy supplier. The heating of the substrate plate 6 can alternatively also be achieved through a radiating beam. A special arrangement is the case of a catalytic surface of the substrate plate 6. This can be achieved either by depositing a catalytic layer upon a non-catalytic substrate material or by using a catalytic substrate material. The first alternative is very interesting for creating patterns on a substrate. The catalytic species is then patterned using a known lithographical process and afterwards the catalytic species serves to decompose the precursor molecules, thereby readily depositing a layer of a metal or metal compound. Another important characteristical feature of a catalytic species is the fact that it provides a self-limiting growth of the deposited layer. When the catalytic species is consumed growth stops. Another field of use is the possibility to sandwich the precursor molecules between several layers of the catalytic species.

Further the decomposition means 40 may be an electronic, ionic or electromagnetic radiating beam. The beam delivers the energy to crack the precursor molecules. Also here the mean-free-path-length should best be held long enough to keep the probability of gasphase decomposition low. When the electromagnetic radiating beam 40 is focused, for instance using a laser beam, also patterns can be created on the substrate plate 6. The electromagnetic radiating beam can particularly comprise UV-light, X-ray and/or γ-radiation.

All mentioned decomposition means can be applied in form of focused beams and as such be used to delimit decomposition as well as deposition to a defined small area on the surface of the substrate plate 6. Thereby arbitrary patterns can be grown on the substrate plate 6 irrespect to the substrate properties, particularly the heat conductivity. Optimal patterning can be achieved by extreme focusing and provision of shortest free beam lengths, i.e. the distances between the introduction positions 47, 48, 49 and the substrate plate 6.

The number of effusion cells can be chosen arbitrarily. All dimensions and forms of different parts shown in the figures are only for sake of example and can be varied without leaving the scope of the invention. Also the shown proportions have been chosen non-realistic for sake of delivering a well-ordered arrangement.

**Claims**

1. Method for depositing a metal or a compound of said metal on a surface of a substrate body (6), said substrate body (6) having a predetermined substrate temperature ($T_s$) and being situated inside a reaction chamber (1), whereby a metal-organic precursor (18, 28) having a predetermined decomposition temperature ($T_{cr}$) and containing said metal is introduced into said reaction chamber (1), characterized in that said metal-organic precursor (18, 28) is chosen to have a volatility temperature ($T_v$) which is sufficiently high that said metal-organic precursor (18, 28) remains in condensated form at chamber walls around said substrate body (6) when it gets into contact with said chamber walls and that said substrate temperature ($T_s$) is kept below said decomposition temperature ($T_{cr}$) and that a decomposition means (37) is introduced into said reaction chamber (1) which decomposition means (37) directly decomposes said metal-organic precursor (18, 28) into said metal or said compound.

2. Method according to claim 1, characterized in that the mean-free-path length is kept in a range which allows only few gas phase interactions of the metal-organic precursor (18, 28) with the decomposition means (37).

3. Method according to claim 1 or 2, characterized in that the decomposition means (37) comprises chemical reactive species, preferrably chosen to comprise atomic nitrogen, fluorine, oxygen, hydrogen and/or reactive molecules like HF, $NO_2$ and/or reactive radicals like $NH_2$·, NO·, OH· and/or ionic species of molecules or atoms like $Ar^+$, $O^-$, $N^-$, $O_2^-$ and/or electrons.

4. Method according to one of claims 1 to 3, characterized in that the metal compound is deposited and that the chemical reactive species is chosen so that said compound comprises a fluoride, oxide, nitride, chloride, hydride.

5. Method according to one of claims 1 to 4, characterized in that the decomposition means (37) comprises an ionic or electronic or electromagnetic radiating beam, preferrably a light beam, particularly a laser light beam and-or that the decomposition means (37) comprises catalytic species which preferrably is introduced into the reaction chamber (1) before the molecular precursor beam (17, 27) is introduced, particularly together with the substrate body (6).

6. Method according to one of claims 1 to 5, characterized in that the precursor (18, 28) is derived from porphyrine, in particular tetra-azaporphyrine, especially phthalocyanine.

7. Method according to one of claims 1 to 6, characterized in that the substrate temperature ($T_s$) is chosen as optimal temperature for the crystal growth process of the metal or metal compound.

8. Method according to claim 7, characterized in that said substrate body (6) is heated through irradiating said substrate body (6) with a radiation to achieve said optimal temperature.

9. Use of a precursor (18, 28) molecule containing one or several atoms of a metal and a porphyrine-derived ligand for deposition of said metal or a compound of said metal on a surface of a substrate body (6), characterized in that said precursor (18, 28) molecule is decomposed underneath its decomposition temperature ($T_{cr}$).

10. Use of a precursor (18, 28) molecule according to claim 9, characterized in that the precursor (18, 28) molecule is decomposed on the substrate body (6).

11. Use of a precursor (18, 28) molecule according to claim 9 or 10, characterized in that the decomposition is assisted by UV light or by laser light and/or by a catalytic species and/or by a chemical reactive species and/or ions and/or electrons and/or by a plasma.

**Patentansprüche**

1. Ein Verfahren zum Ablegen eines Metalls oder einer Verbindung des Metalls auf einer Oberfläche eines Substratkörpers (6), wobei der Substratkörper (6) eine festgelegte Substrattemperatur ($T_s$) hat und sich in einer Reaktionskammer (1) befindet, und wobei ein metallorganisches Vorprodukt (18, 28), das eine festgelegte Abbautemperatur ($T_{cr}$) hat und das Metall enthält, in die Reaktionskammer (1) eingeführt wird, und wobei das Verfahren dadurch gekennzeichnet ist, daß das metallorganische Vorprodukt (18, 28) eine Verflüchtigungstemperatur ($T_v$) hat, die ausreichend hoch ist, damit das metallorganische Vorprodukt (18, 28) in kondensierter Form an den Kammerwänden um den Substratkörper (6) haften bleibt, wenn es in Berührung mit den Kammerwänden kommt, und daß die Substrattemperatur ($T_s$) unter der Abbautemperatur ($T_{cr}$) gehalten wird und daß ein Abbaumittel (37) in die Reaktionskammer (1) geleitet wird, wobei das Abbaumittel (37) das metallorganische Vorprodukt (18, 28) direkt in das Metall oder die Verbindung zerlegt.

2. Ein Verfahren nach Anspruch 1, das dadurch gekennzeichnet ist, daß die durchschnittliche freie Pfadlänge in einem Bereich gehalten wird, der nur wenige Gasphaseninteraktionen des metallorganischen Vorprodukts (18, 28) mit dem Abbaumittel (37) erlaubt.

3. Ein Verfahren nach Anspruch 1 oder 2, das dadurch gekennzeichnet ist, daß das Abbaumittel (37) chemische Reaktionsmittel enthält, die vorzugsweise atomische Stickstoff-, Fluor-, Sauerstoff-, Wasserstoff- und/oder reaktive Moleküle wie HF, $NO_2$ und/oder reaktive Radikale wie $NH_2\cdot$, $NO\cdot$, $OH\cdot$ und/oder ionische Molekül- oder Atomarten wie $Ar^+$, $O^-$, $N^-$, $O_2^-$ und/oder Elektronen enthalten.

4. Ein Verfahren nach einem der Ansprüche 1 bis 3, das dadurch gekennzeichnet ist, daß die Metallverbindung abgelegt wird und das chemische Reaktionsmittel so ausgewählt wird, daß die Verbindung Fluorid, Oxid, Nitrid, Chlorid und Hydrid enthält.

5. Ein Verfahren nach einem der Ansprüche 1 bis 4, das dadurch gekennzeichnet ist, daß das Abbaumittel (37) einen ionischen oder elektronischen oder elektromagnetischen Strahl enthält, vorzugsweise einen Lichtstrahl, insbesondere einen Laserlichtstrahl, und/oder daß das Abbaumittel (37) ein katalytisches Mittel enthält, das vorzugsweise vor dem molekularen Vorproduktmittel (17, 27) vor allem zusammen mit dem Substratkörper (6) in die Reaktionskammer eingeführt wird.

6. Ein Verfahren nach einem der Ansprüche 1 bis 5, das dadurch gekennzeichnet ist, daß das Vorprodukt (18, 28) auf Porphyrinbasis, insbesondere Tetra-Azaporphyrin, insbesondere Phthalocyanin, beruht.

7. Ein Verfahren nach einem der Ansprüche 1 bis 6, das dadurch gekennzeichnet ist, daß die Substrattemperatur ($T_s$) als optimale Temperatur für den Kristallbildungsprozess des Metalls oder der Metallverbindung ausgewählt wird.

8. Ein Verfahren nach Anspruch 7, das dadurch gekennzeichnet ist, daß der Substratkörper (6) durch die Bestrahlung des Substratkörpers (6) erhitzt wird, um die optimale Temperatur zu erhalten.

9. Die Verwendung eines Moleküls eines Vorprodukts (18, 28), das eines oder mehrere Atome eines Metalls und einen von Porphyrin abstammenden Liganden zum Ablegen des Metalls oder einer Verbindung des Metalls auf einer Oberfläche eines Substratkörpers (6) enthält, wobei diese Verwendung dadurch gekennzeichnet ist, daß das Molekül des Vorprodukts (18, 28) unter seiner Abbautemperatur ($T_{cr}$) abgebaut wird.

10. Die Verwendung eines Moleküls eines Vorprodukts (18, 28) nach Anspruch 9, die dadurch gekennzeichnet ist, daß das Molekül des Vorprodukts (18, 28) auf dem Substratkörper (6) abgebaut wird.

11. Die Verwendung eines Moleküls eines Vorprodukts (18, 28) nach Anspruch 9 oder 10, die dadurch gekennzeichnet ist, daß der Abbau mit UV-Licht oder Laserlicht und/oder mit Hilfe eines katalytischen Mittels und/oder mit Hilfe eines chemischen Reaktionsmittels und/oder Ionen und/oder Elektronen und/oder mit Hilfe eines Plasmas erfolgt.

**Revendications**

1. Procédé destiné à déposer un métal ou un composé dudit métal sur une surface d'un corps de substrat (6), ledit corps de substrat (6) présentant une température de substrat prédéterminée ($T_s$) et étant situé à l'intérieur d'une chambre réactionnelle (1), grâce auquel un précurseur organo-métallique (18, 28) présentant une température de décomposition prédéterminée ($T_{cr}$) et contenant ledit métal est introduit jusque dans ladite chambre réactionnelle (1), caractérisé en ce que ledit précurseur organométallique (18, 28) est choisi de manière à présenter une température de volatilité ($T_v$) qui est suffisamment élevée pour que ledit précurseur organométallique (18, 28) reste sous forme condensée au niveau des parois de la chambre autour dudit corps de substrat (6) lorsqu'il vient en contact avec lesdites parois de la chambre et en ce que ladite température de substrat ($T_s$) est maintenue au-dessous de ladite température de décomposition ($T_{cr}$) et en ce qu'un moyen de décomposition (37) est introduit jusque dans ladite chambre réactionnelle (1) lequel moyen de décomposition (37) décompose directement ledit précurseur organo-métallique (18, 28) en ledit métal ou ledit composé.

2. Procédé selon la revendication 1, caractérisé en ce que la longueur de trajet libre moyen est maintenue dans une plage qui permet uniquement quelques interactions en phase gazeuse du précurseur organo-métallique (18, 28) avec le moyen de décomposition (37).

3. Procédé selon la revendication 1 ou 2, caractérisé en ce que le moyen de décomposition (37) comprend une espèce réactive chimique, de préférence choisie de manière à comprendre de l'azote, du fluor, de l'oxygène, de l'hydrogène atomiques et/ou des molécules réactives comme HF, NO et/ou des radicaux réactifs comme $NH_2\cdot$, $NO\cdot$, $OH\cdot$ et/ou des espèces ioniques de molécules ou d'atomes comme $Ar^+$, $O^-$, $N^-$, $O^-$ et/ou des électrons.

4. Procédé selon l'une des revendications 1 à 3, caractérisé en ce que le composé métallique est déposé et en ce que l'espèce réactive chimique est choisie de sorte que ledit composé comprenne un fluorure, un oxyde, un nitrure, un chlorure, un hydrure.

5. Procédé selon l'une des revendications 1 à 4, caractérisé en ce que le moyen de décomposition (37) comprend un faisceau de rayonnement ionique ou électronique ou électromagnétique, de préférence un faisceau de lumière, en particulier un faisceau de lumière laser et/ou en ce que le moyen de décomposition (37) comprend une espèce catalytique qui de préférence, est introduite jusque dans la chambre réactionnelle (1) avant que le faisceau de précurseur moléculaire (17, 27) soit introduit, en particulier en même temps que le corps de substrat (6).

6. Procédé selon l'une des revendications 1 à 5, caractérisé en ce que le précurseur (18, 28) est obtenu à partir d'une porphyrine, en particulier une tétra-azaporphyrine, et tout particulièrement une phtalocyanine.

7. Procédé selon l'une des revendications 1 à 6, caractérisé en ce que la température de substrat ($T_s$) est choisie en tant que température optimale pour le procédé de croissance des cristaux du métal ou du composé métallique.

8. Procédé selon la revendication 7, caractérisé en ce que ledit corps de substrat (6) est chauffé grâce à l'illumination dudit corps de substrat (6) par un rayonnement de façon à obtenir ladite température optimale.

9. Utilisation d'une molécule de précurseur (18, 28) contenant un ou plusieurs atomes d'un métal et d'un ligand provenant d'une porphyrine destinée au dépôt dudit métal ou d'un composé dudit métal sur une surface d'un corps de substrat (6), caractérisée en ce que ladite molécule de précurseur (18, 28) est décomposée au-dessous de sa température de décomposition ($T_{cr}$).

10. Utilisation d'une molécule de précurseur (18, 28) selon la revendication 9, caractérisée en ce que la molécule de précurseur (18, 28) est décomposée sur le corps de substrat (6).

11. Utilisation d'une molécule de précurseur (18, 28) selon la revendication 9 ou 10, caractérisée en ce que la décomposition est aidée par une lumière UV ou par une lumière laser et/ou par une espèce catalytique et/ou par une espèce réactive chimique et/ou des ions et/ou des électrons et/ou par un plasma.

Fig. 1

Fig. 2